# FASCICULE DE BREVET EUROPEEN

(11) **EP 1 420 262 B1**
(45) Date de publication et mention de la délivrance du brevet: **23.06.2010**
(21) Numéro de dépôt: 03356173.9
(22) Date de dépôt: 10.11.2003
(51) Int. Cl.: G01R 31/42, G01R 31/27

(54) **Procédé et système de détection d'au moins une défaillance d'au moins un interrupteur dans un convertisseur électronique**
Verfahren und Vorrichtung zur Detektion mindestens eines Fehlers mindestens eines Schalters in einem elektronischen Umwandler
Method and system for detecting at least one failure of at least one switch in an electronic converter

(30) Priorité: 12.11.2002 FR 0214126
(43) Date de publication de la demande: 19.05.2004
(73) Titulaire: ALSTOM Transport SA, 92300 Levallois-Perret (FR)
(72) Inventeur: Belin, Sébastien, 65800 Aureilhan (FR); Debruyne, Marc, 65100 Bartres (FR); Boyer, Michel, 65000 Tarbes (FR)
(74) Mandataire: Myon, Gérard Jean-Pierre

(56) Documents cités:
- EP-A1- 0 848 492
- FR-A- 2 820 561
- JP-A- 6 205 599
- JP-A- 8 080 056
- US-A- 5 266 891

## Description

L'invention concerne un procédé et un système de détection d'au moins une défaillance d'au moins un interrupteur à tester présent dans un convertisseur électronique comportant des générateurs raccordés entre eux par l'intermédiaire d'interrupteurs commandables, de manière à raccorder les mêmes générateurs soit en parallèle, soit en série.

De tels convertisseurs sont connus sous le terme de convertisseur SPARC (Serial and Parallel Auto-Regulated Configuration) et divulgués par exemple dans la demande de brevet français FR 2 820 561. Ils sont mis en oeuvre par exemple, dans les circuits d'alimentation de machines électriques tournantes utilisées pour la traction ferroviaire. Ces convertisseurs comportent un grand nombre d'interrupteurs et il est nécessaire de pouvoir détecter rapidement et simplement une défaillance de ceux-ci. A cet effet, classiquement, un procédé de test par retour d'état est utilisé. Ce procédé consiste à relever la valeur de la tension aux bornes de l'interrupteur à tester et à comparer cette valeur à la valeur théorique qui devrait être relevée en l'absence de défaillance de cet interrupteur à tester. La différence entre la valeur réellement relevée et la valeur théorique permet de détecter une défaillance de l'interrupteur. Toutefois, la mise en oeuvre de ce procédé est onéreuse. En effet, pour relever la tension aux bornes de chaque interrupteur à tester, il est nécessaire d'utiliser des conducteurs électriques supplémentaires spécialement dédiés à cet usage. La présence de ces conducteurs supplémentaires augmente le coût de réalisation du circuit électronique.

De plus, les conducteurs supplémentaires rétablissent une liaison électrique entre un côté haute tension représenté par le convertisseur SPARC et un côté basse tension où la comparaison entre les valeurs relevées et théoriques est réalisée. Une telle liaison électrique entre un côté haute tension et un côté basse tension nécessite la présence de nombreux circuits d'isolation électrique. Ces circuits d'isolation électrique augmentent également le coût de la mise en oeuvre des procédés connus.

US 5 266 891 A divulgue un onduleur dans lequel chaque interrupteur est associé avec un capteur de courant et un capteur de tension respectifs.

L'invention vise à remédier à cet inconvénient en proposant un procédé de détection de défaillance d'au moins un interrupteur moins onéreux à mettre en oeuvre.

L'invention a donc pour objet un procédé de détection conforme à la revendication 1.

Dans le procédé ci-dessus, un circuit électrique fermé permettant de tester un ou plusieurs interrupteurs est réalisé en raccordant entre eux les conducteurs mêmes du convertisseur. Ainsi, l'établissement de ce circuit électrique fermé ne nécessite aucun conducteur électrique supplémentaire.

Ensuite, un courant est engendré à l'aide d'une source d'alimentation raccordée à des bornes d'entrée ou de sortie du convertisseur. Dès lors, il n'est pas nécessaire non plus d'utiliser des conducteurs électriques supplémentaires.

Finalement, un paramètre de fonctionnement, relevé aux bornes d'entrée ou de sortie du convertisseur, est utilisé pour l'analyse et la détection éventuelle de défaillances d'un interrupteur. Puisque ce paramètre est mesuré aux bornes du convertisseur, et non pas aux bornes de chaque interrupteur à tester, cela nécessite, au plus, un ou deux conducteurs électriques supplémentaires, pour raccorder un appareil d'analyse. Ainsi, le nombre de conducteurs électriques supplémentaires nécessaires pour mettre en oeuvre ce procédé est nettement inférieur à celui nécessaire pour mettre en oeuvre les procédés connus. Le procédé ci-dessus est donc moins onéreux et plus simple.

D'autres caractéristiques facultatives du procédé conforme à l'invention apparaissent dans les revendications dépendantes.

L'invention a également pour objet un système de détection conforme à la revendication 10.

L'invention a également pour objet un support d'enregistrement d'informations conforme à la revendication 11 et comportant des instructions pour l'exécution d'un procédé de détection d'au moins une défaillance d'au moins un interrupteur conforme à l'invention lorsque lesdites instructions sont exécutées par un calculateur électronique.

L'invention sera mieux comprise à la lecture de la description qui va suivre, donnée uniquement à titre d'exemple, et faite en se référant aux dessins, sur lesquels :
- la figure 1 est une illustration schématique partielle d'un convertisseur SPARC sur lequel est appliqué un système de détection de défaillance d'au moins un interrupteur conforme à l'invention ;
- la figure 2 est un organigramme d'un procédé de détection d'un interrupteur en court-circuit conforme à l'invention ;
- la figure 3 est un organigramme d'un procédé de détection d'un interrupteur bloqué dans un état ouvert conforme à l'invention ; et
- la figure 4 est un organigramme d'une variante d'un procédé de détection d'une défaillance d'un interrupteur conforme à l'invention.

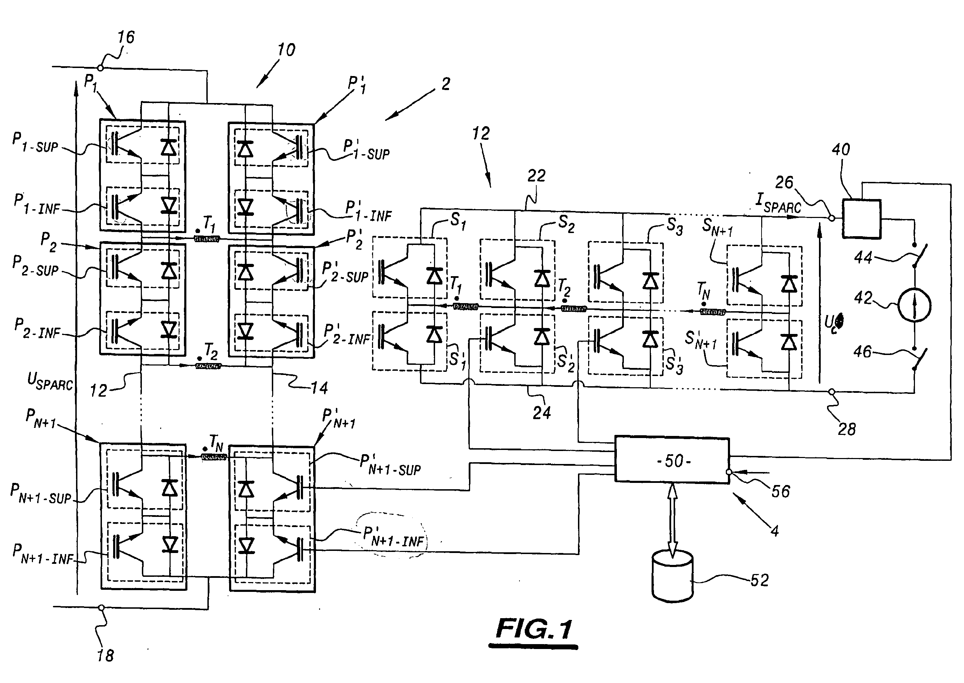

La figure 1 représente un convertisseur remplissant les fonctions d'un transformateur à rapport de transformation variable, désigné par la référence générale 2. Il est associé à un système 4 de détection de défaillance des interrupteurs du transformateur 2.

Le convertisseur 2 est connu sous le terme de "convertisseur SPARC" dont la structure générale est, par exemple, divulguée dans la demande de brevet FR 2 820 561. Le convertisseur 2 étant connu, seuls les détails nécessaires à la compréhension du système de détection 4 seront décrits ici.

Sur la figure 1, les traits en pointillés à la place de conducteurs électriques indiquent qu'une partie du schéma électrique a été omise pour simplifier l'illustration.

Le convertisseur 2 est formé d'un ensemble de transformateurs indépendants magnétiquement les uns des autres. En cela, le convertisseur SPARC se distingue des transformateurs à rapport de transformation variable connus. Les enroulements des transformateurs sont raccordés les uns aux autres par l'intermédiaire d'interrupteurs. Ces interrupteurs sont commandables pour raccorder ces enroulements en parallèle et/ou en série, de manière à faire varier le rapport de transformation global du convertisseur SPARC.

Le rapport de transformation global du convertisseur SPARC est ici défini comme étant le rapport de la tension de sortie U_{C} sur la tension d'entrée U_{SPARC}.

Le convertisseur 2 comporte ici N transformateur notés respectivement T₁, T₂, ... Tᵢ ... T_{N}, où N est un nombre entier supérieur à 2 et, de préférence, supérieur à 10, 20 ou 30.

Le convertisseur 2 est formé d'un circuit électrique primaire 10 et d'un circuit électrique secondaire 12 isolés électriquement l'un de l'autre.

Le circuit électrique primaire 10 présente une structure générale en forme d'échelle verticale dans laquelle le deux montants verticaux sont formés par des conducteurs électriques 12 et 14 et les barreaux horizontaux sont chacun formés par un enroulement primaire d'un des transformateurs Tᵢ raccordé de part et d'autre aux conducteurs électriques 12, 14 par chacune de ses extrémités. Les N enroulements primaires des transformateurs Tᵢ sont donc raccordés en parallèle entre les conducteurs 12 et 14.

Les conducteurs 12 et 14 sont court-circuités entre eux à chacune de leurs extrémités.

Ces extrémités court-circuitées sont raccordées respectivement à des bornes d'entrée 16, 18 du convertisseur 2 entre lesquelles s'établit la tension U_{SPARC}.

Chaque conducteur 12, 14 porte un jeu de N+1 interrupteurs, chaque interrupteur étant placé entre deux points respectifs de connexion d'enroulements primaires, à l'exception des interrupteurs situés aux extrémités des conducteurs 12, 14 qui sont raccordés entre un point de connexion d'un enroulement primaire et les extrémités court-circuitées des conducteurs 12, 14.

Les N+1 interrupteurs du conducteur 12 sont notés dans l'ordre P₁ à P_{N+1} et les N+1 interrupteurs du conducteur 14 sont notés dans l'ordre P'₁ à P'_{N+1}, l'indice 1 et l'indice N+1 désignant les interrupteurs d'extrémités.

Dans la suite de la description, on désignera par "étage élémentaire" le circuit formé par deux enroulements primaires consécutifs raccordés en parallèle et les deux interrupteurs placés sur les conducteurs 12, 14 entre les points de connexion de ces deux enroulements primaires.

Le circuit électrique secondaire 12 présente également une structure en forme d'échelle, mais, cette fois-ci, horizontale. Les deux montants horizontaux de l'échelle sont formés par des conducteurs 22, 24 et chaque barreau par une paire d'interrupteurs raccordés en série.

Le circuit électrique 12 comporte les enroulements secondaires des transformateurs Tᵢ raccordés en série. Chaque enroulement secondaire est raccordé entre deux barreaux consécutifs et, plus précisément, au milieu de la paire d'interrupteurs de chacun des barreaux verticaux.

Une extrémité de chacun des conducteurs 22 et 24 est raccordée respectivement à une borne de sortie 26 et une borne de sortie 28 du convertisseur 2. La tension U_{C} s'établit entre les bornes de sortie 26 et 28.

Les N+1 interrupteurs raccordés chacun entre l'extrémité d'un enroulement secondaire et le conducteur 22 sont notés dans l'ordre respectivement S₁ à S_{N+1}.

L'indice des interrupteurs Pᵢ, P'ᵢ, Sᵢ, S'ᵢ correspond à celui des transformateurs Tᵢ auquel ils sont associés et l'indice N+1 correspond à celui du transformateur T_{N}.

Dans la suite de la description, les interrupteurs Pᵢ et Sᵢ, respectivement P'ᵢ et S'ᵢ, ayant le même indice, sont dits correspondants car ils remplissent des fonctions similaires vis-à-vis chacun de leur enroulement respectif.

De manière à ce que le convertisseur 2 soit réversible en puissance, c'est-à-dire qu'il soit capable à la fois de transmettre et de recevoir en alternance de la puissance à partir des bornes de sortie 26, 28, les interrupteurs du circuit électrique primaire sont bidirectionnels en tension et en courant et les interrupteurs du circuit électrique secondaire sont bidirectionnels uniquement en courant.

A cet effet, chaque interrupteur Pᵢ ou P'ᵢ est formé de deux dispositifs de commutation bidirectionnels en courant et monodirectionnels en tension raccordés en série tête-bêche. Ici, le dispositif de commutation bidirectionnel en courant et monodirectionnel en tension est formé par un transistor de puissance IGBT (Insulated Gate Bipolar Transistor) aux bornes duquel est raccordée une diode en position antiparallèle.

Le dispositif de commutation de chaque interrupteur Pᵢ, P'ᵢ qui est traversé en premier par un courant entrant par la borne d'entrée 16 est référencé P_{i-SUP} dans l'interrupteur Pᵢ et P'_{i-SUP} dans l'interrupteur P'ᵢ. L'autre dispositif de commutation de chacun des interrupteurs Pᵢ est référencé P_{i-INF} pour l'interrupteur Pᵢ et P'_{i-INF} pour l'interrupteur P'ᵢ.

A titre d'exemple, chacun des interrupteurs Sᵢ et S'ᵢ est structurellement identique à un dispositif de commutation des interrupteurs Pᵢ. Le transistor de puissance IGBT formant les interrupteurs Sᵢ a son collecteur directement raccordé au conducteur 22 et son émetteur directement raccordé entre deux enroulements secondaires. Au contraire, l'émetteur du transistor de puissance IGBT des interrupteurs S'ᵢ est raccordé directement au conducteur 24 et son collecteur est raccordé directement entre deux enroulements secondaires.

Un capteur de courant 40 et une source d'alimentation continue 42 sont raccordés en série entre les bornes de sortie 26 et 28.

Le capteur de courant 40 est propre à mesurer le courant I_{SPARC} fourni à la sortie du convertisseur 2.

La source d'alimentation 42 est destinée à alimenter en énergie les enroulements secondaires du circuit électrique secondaire 12. Cette source d'alimentation 42 est raccordée aux bornes de sortie 26, 28 par l'intermédiaire d'interrupteurs commandables 44, 46 de manière à pouvoir être raccordée aux bornes de sortie 26 et 28 uniquement pendant des périodes de test de défaillance d'interrupteurs.

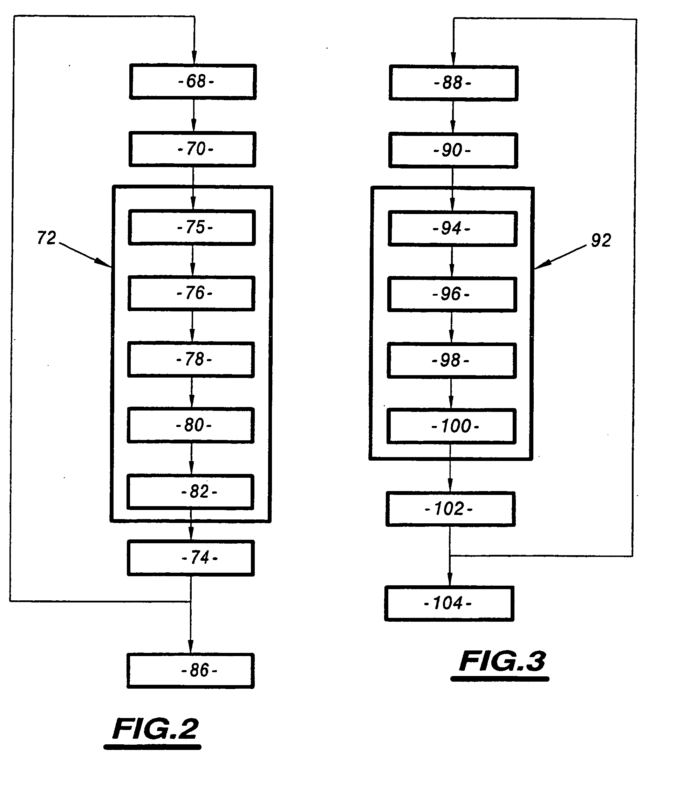

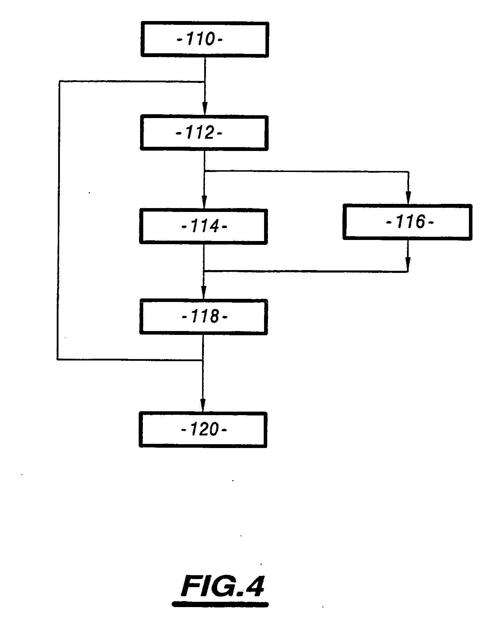

Dans le cas des procédés des figures 2 et 3, la source d'alimentation 42 est une source de tension continue, dans le cas du procédé de la figure 4, la source d'alimentation 42 est une source de courant continu.

Le système de détection de défaillance 4 est formé, par exemple, par un calculateur programmable 50 propre à exécuter des instructions enregistrées sur un support d'enregistrement d'informations 52. Les instructions enregistrées sur le support 52 sont réalisées et enregistrées de façon conventionnelle pour que le calculateur 50, lorsqu'il les exécute, réalise les procédés qui seront décrits en regard des figures 2, 3 et 4.

Ici, ce calculateur 50 est raccordé à la grille de chacun des transistors de puissance des interrupteurs Pᵢ, P'ᵢ, Sᵢ et S'ᵢ de manière à appliquer sur celle-ci une tension de 0 V pour rendre le transistor non-passant (ouvert) et de 15 V pour rendre le transistor passant (fermé).

De manière à simplifier l'illustration de la figure 1, seules quelques unes des liaisons électriques entre les grilles des transistors de puissance et le calculateur 50 ont été représentées.

Le calculateur 50 est également raccordé au capteur de courant 40.

De préférence, le calculateur 50 est également apte à commander la commutation de chacun des interrupteurs du convertisseur 2 pour que le rapport de transformation global du convertisseur 2 se rapproche le plus possible d'une consigne de rapport de transformation global souhaité reçue par l'intermédiaire d'une entrée 56. Sur ce point, le procédé de commande mis en oeuvre par le calculateur 50 est, par exemple, identique à celui mis en oeuvre dans la demande de brevet FR 2 820 561 et ne sera donc pas décrit ici.

Le fonctionnement du système de détection 4 va maintenant être décrit, d'abord dans le cas de la détection d'un interrupteur en court-circuit en regard de la figure 2, puis, ensuite, dans le cas de la détection d'un interrupteur bloqué dans un état non passant, en regard de la figure 3.

Le procédé de la figure 2 sera décrit dans le cas particulier où l'interrupteur testé est un interrupteur du circuit électrique primaire.

Le calculateur 50 commence par raccorder, à l'étape 68, la source de tension 42 aux bornes 26, 28 et par sélectionner, à l'étape 70, un interrupteur du circuit électrique primaire 10 à tester, par exemple, l'interrupteur P₂.

Chaque interrupteur du circuit électrique primaire étant formé de deux dispositifs de commutation, le calculateur teste ici d'abord le dispositif de commutation supérieur, à l'étape 72, c'est-à-dire ici P_{2-SUP} et, ensuite, le dispositif de commutation inférieur, c'est-à-dire ici P_{2-INF}, à l'étape 74.

A l'étape 72, le calculateur commence par commander, lors de l'opération 75, l'ouverture du transistor de P_{2-SUP} et par créer, lors de l'opération 76, le circuit électrique fermé le plus petit possible qui relie entre elles les bornes de l'interrupteur P_{2-SUP}. A cet effet, il commande ici uniquement la fermeture du transistor de P'_{2-INF} pour rendre conducteur l'interrupteur P'₂.

Ensuite, toujours lors de l'étape 72, le calculateur 50 commande, lors d'une opération 78, la fermeture des interrupteurs S₁, S'₂ et S₃ du circuit électrique secondaire 12 de manière à appliquer la tension U_{C} générée par la source de tension 42 aux extrémités des enroulements secondaires des transformateurs T₁ et T₂. Dans cette configuration, les enroulements secondaires des transformateurs T₁ et T₂ sont raccordés en parallèle aux bornes de la source de tension 42 et en sens inverse, de sorte qu'une tension proportionnelle à U_{C} apparaît dans l'enroulement primaire du transformateur T₁ et une tension proportionnelle à -Uc apparaît dans l'enroulement primaire du transformateur T₂. Ainsi, le calculateur 50 en commandant les interrupteurs du circuit électrique secondaire crée, par l'intermédiaire des transformateurs, une différence de potentiel dans le circuit électrique fermé formé lors de l'opération 76.

Si le dispositif de commutation P_{2-SUP} est dans l'état non-passant, aucun courant n'apparaît dans le circuit électrique fermé. Dans le cas contraire, c'est-à-dire que malgré la commande appliquée lors de l'opération 75 P_{2-SUP} est resté dans l'état passant, alors un courant de court-circuit apparaît dans le circuit électrique fermé.

Ce courant de court-circuit est répercuté par l'intermédiaire des transformateurs T₁ et T2 aux enroulements secondaires correspondants et se traduit par une brusque augmentation du courant I_{SPARC} mesurée par le capteur de courant 40.

Le calculateur analyse alors, lors de l'opération 80, l'évolution du courant I_{SPARC}. Typiquement, si un courant de court-circuit circule dans le circuit électrique fermé, le courant I_{SPARC} atteint en quelques microsecondes une valeur proche de 1000 A. Dans le cas contraire, à cause du fait que les transformateurs ne sont pas parfaits, un courant faible apparaît quand même. Typiquement, le courant faible I_{SPARC} atteint la valeur de 10 A en quelques microsecondes. La différence d'évolution du courant dans ces deux situations est suffisante pour que le calculateur 50 puisse faire la différence. Ainsi, si le courant I_{SPARC} monte très rapidement, le calculateur en déduit que le dispositif de commutation P_{2-SUP} est en court-circuit.

Ensuite, lors de l'opération 82, avant que le courant I_{SPARC} n'atteigne un niveau qui risquerait d'endommager le convertisseur 2, le calculateur 50 commande l'ouverture du dispositif de commutation P'_{2-INF} de manière à interrompre la montée du courant I_{SPARC}.

Pour tester le dispositif de commutation de P_{2-INF} lors de l'étape 74, le calculateur 50 réalise les mêmes opérations que lors de l'étape 72 en commandant l'interrupteur P'_{2-SUP} à la place de l'interrupteur P'_{2-INF} et les interrupteurs S'₁, S₂, S'₃ à la place des interrupteurs S₁, S'₂, S₃.

A l'issue de l'étape 74, le calculateur peut soit revenir à l'étape 70 pour sélectionner un autre interrupteur à tester, soit procéder à une étape 86 de passage en mode de fonctionnement dégradé. En effet, même lorsqu'un interrupteur du circuit électrique primaire 10 est défaillant, le convertisseur 2 reste utilisable moyennant une adaptation de sa commande.

Lors du procédé de détection d'un interrupteur bloqué dans l'état non passant, le calculateur 50 débute par une étape 88 de connexion de la source de tension 42 aux bornes 26, 28, suivie d'une étape 90 de sélection de l'étage du circuit électrique primaire à tester. Ici, l'étage comportant les interrupteurs P₂ et P'₂ est sélectionné.

Ensuite, puisque chaque interrupteur est ici formé de deux dispositifs de commutation, le calculateur procède, à l'étape 92, au test simultané des dispositifs de commutation P_{2-SUP} et P'_{2-INF}. A cet effet, il commande uniquement la fermeture, lors de l'opération 94, de ces deux dispositifs de commutation P_{2-SUP} et P'_{2-INF}. La fermeture de ces deux interrupteurs forme, s'ils ne sont pas défaillants, un circuit électrique fermé passant par le transistor de puissance de P'_{2-INF}, la diode en position antiparallèle de P'_{2-SUP}, le transistor de puissance de P_{2-SUP}, la diode en position antiparallèle de P_{2-INF} et les enroulements primaires de T₁ et T₂.

On notera que, puisque les dispositifs de commutation à tester et ceux à commander pour créer le circuit électrique fermé sont les mêmes, l'opération 94 remplit ici simultanément les fonctions des opérations 75 et 76 de la figure 2.

Les trois opérations suivantes 96, 98 et 100, réalisées par le calculateur 50 lors de l'étape 92, sont respectivement identiques aux opérations 78, 80 et 82 de la figure 2.

On notera cependant que, lors de l'opération 98, contrairement à l'opération 80, une défaillance est détectée si l'évolution du courant I_{SPARC} ne correspond pas à un courant de court-circuit dans le circuit électrique fermé.

A la suite de l'étape 92, le calculateur procède à l'étape 102 de test des dispositifs de commutation P_{2-INF} et P'_{2-SUP}. Les opérations réalisées lors de cette étape 102 sont les mêmes que celles réalisées lors de l'étape 92 en commandant P_{2-INF} et P'_{2-SUP} à la place de P_{2-SUP} et P'_{2-INF} et S'₁, S₂, S'₃ à la place de S₁, S'₂ et S₃.

Une fois l'étape 102 finie, le calculateur peut soit retourner à l'étape 90 pour sélectionner un nouvel étage à tester, soit procéder à une étape 104, similaire à l'étape 86, de commande du convertisseur 2 dans un mode dégradé.

Pour les étages d'extrémité, la différence de potentiel est créée, lors de l'étape 78 ou 98, à l'aide d'un seul enroulement primaire T₁ ou T_{N}.

Le procédé de la figure 4 est un procédé de détection d'une défaillance d'un interrupteur du circuit électrique secondaire 12.

Le calculateur 50 commence, lors d'une étape 110, à raccorder la source de courant 42 aux bornes 26 et 28. Ensuite, lors d'une étape 112, il sélectionne l'interrupteur Sᵢ ou S'ᵢ à tester. Pour la suite des explications, on suppose que l'interrupteur sélectionné est l'interrupteur Sᵢ.

Le calculateur 50 poursuit en commandant, à l'étape 114, la fermeture de l'interrupteur S'ᵢ pour créer un circuit électrique fermé reliant les bornes de l'interrupteur Sᵢ aux bornes de la source de courant 42.

Simultanément, à l'étape 116, le calculateur commande l'ouverture de l'interrupteur Sᵢ si la défaillance à tester est un blocage de l'interrupteur Sᵢ dans un état passant. Dans le cas contraire, c'est-à-dire si la défaillance à tester est un blocage de l'interrupteur Sᵢ dans un état non passant, le calculateur 50 commande la fermeture de cet interrupteur Sᵢ.

Une fois les interrupteurs Sᵢ et S'ᵢ commandés, le calculateur 50 relève et analyse, à l'étape 118, l'intensité du courant I_{SPARC}. Une défaillance de l'interrupteur Sᵢ est détectée si celui-ci a été commandé pour être ouvert, lors de l'étape 116, et qu'un courant I_{SPARC} correspondant à un courant de court-circuit est relevé. L'intensité du courant de court-circuit est ici égale à l'intensité du courant de la source de courant 42. De même, une défaillance de l'interrupteur Sᵢ est détectée si, lors de l'étape 116, celui-ci a été fermé et qu'une absence de courant de court-circuit est relevée.

Ensuite, le calculateur peut soit procéder à une étape 120 de commande du convertisseur 2 dans un mode dégradé similaire aux étapes 86 et 104, soit retcumer à l'étape 112 pour tester un nouvel interrupteur du circuit électrique secondaire 12.

Les procédés de détection ont été décrits lorsqu'ils sont appliqués à des interrupteurs réalisés à l'aide de transistors IGBT et de diodes. En variante, les procédés et le système décrits ici sont adaptés aux cas où certains des interrupteurs du convertisseur 2 sont réalisés à l'aide de thyristors, de triacs, de transistors à effet de champ ou tout autre dispositif de commutation commandable.

En variante, le procédé et le système décrit ci-dessus pour tester des interrupteurs du circuit électrique primaire 10 est adapté pour tester des interrupteurs du circuit électrique secondaire 12. A cet effet, les procédés de commande des figures 2 et 3 sont modifiés pour que le rôle précédemment joué par les interrupteurs du circuit 12 soit rempli par les interrupteurs du circuit 10 et vice-versa.

Le système et le procédé ont été décrits dans la situation préférée où les interrupteurs à tester sont ceux d'un convertisseur SPARC. En variante, le procédé décrit ci-dessus est adapté à tout type de convertisseur dans lequel il est possible de créer un circuit électrique fermé en commandant des interrupteurs et d'engendrer un courant dans ce circuit électrique fermé à partir d'une source d'alimentation raccordée entre des bornes d'entrée ou de sortie du convertisseur.

## Revendications

1. Procédé de détection d'au moins une défaillance d'au moins un interrupteur commandable à tester présent dans un convertisseur électronique (2) comportant des générateurs (Tᵢ) raccordés entre eux par l'intermédiaire d'interrupteurs commandables (Pᵢ, P'ᵢ, Sᵢ, S'ᵢ), de manière à relier les mêmes générateurs soit en parallèle, soit en série,
**caractérisé en ce que** le procédé comprend les étapes de :
- commander (en 76 ; 94 ; 114) les interrupteurs commandables du convertisseur électronique (2) pour former un circuit électrique fermé unidirectionnel en courant reliant entre elles les bornes du ou de chaque interrupteur commandable à tester,
- commander l'apparition (en 78 ; 96 ; 110) d'un courant dans le circuit électrique fermé, propre à traverser l'interrupteur commandable à tester, à partir d'une source d'alimentation raccordée entre soit des bornes d'entrée, soit des bornes de sortie du convertisseur electronique (2), et
- analyser (en 80 ; 98 ; 118) aux bornes du convertisseur électronique auxquelles est raccordée la source d'alimentation les valeurs d'un paramètre représentatif de l'intensité du courant dans le circuit électrique fermé pour en déduire une information de défaillance dudit au moins un interrupteur commandable à tester.

2. Procédé selon la revendication 1, **caractérisé en ce que**, dans le cas où la défaillance à détecter est un blocage dudit au moins un interrupteur commandable à tester dans un état passant qui permet l'apparition du courant dans le circuit électrique fermé, le procédé comprend l'étape de commander (en 75 ; 116) ledit au moins un interrupteur commandable à tester vers un état non-passant qui ne permet pas l'apparition du courant dans le circuit électrique fermé, et à déduire, lors de l'analyse (en 80 ; 118), que ledit au moins un interrupteur à tester est défaillant si les valeurs du paramètre représentatif de l'intensité du courant correspond à un courant de court-circuit dans le circuit électrique fermé.

3. Procédé selon l'une quelconque des revendications précédentes, **caractérisé en ce que**, dans le cas où la défaillance à détecter est un blocage dudit au moins un interrupteur commandable dans l'état non-passant qui ne permet pas l'apparition du courant dans le circuit électrique fermé, le procédé comprend l'étape de commander (en 94 ; 116) ledit au moins un interrupteur commandable à tester vers l'état passant qui permet l'apparition du courant dans le circuit électrique fermé, et à déduire, lors de l'analyse (en 98; 118), que ledit au moins un interrupteur commandable à tester est défaillant si les valeurs dudit paramètre représentatif de l'intensité du courant correspond à une absence de courant de court-circuit dans le circuit électrique fermé.

4. Procédé selon l'une quelconque des revendications précédentes, pour le convertisseur électronique dans lequel :
- les générateurs sont formés par des enroulements de transformateurs (Tᵢ) indépendants magnétiquement les uns des autres,
- le convertisseur électronique (2) comporte un circuit électrique primaire (10) raccordant entre eux les enroulements primaires des transformateurs (Tᵢ), et un circuit électrique secondaire (12) raccordant entre eux les enroulements secondaires, les circuits électriques primaire et secondaire étant électriquement isolés l'un de l'autre, et
**caractérisé en ce que** le procédé comporte l'étape de commander (en 75 ; 94) certains interrupteurs commandables d'un seul de ces circuits électriques primaire et secondaire (10 ; 12) pour former ledit circuit électrique fermé et de commander (en 76 ; 96) certains interrupteurs commandables de l'autre circuit électrique primaire ou secondaire pour créer une différence de potentiel propre à engendrer un courant dans le circuit électrique fermé.

5. Procédé selon la revendication 4, **caractérisé en ce qu'**il consiste à alimenter au moins deux enroulements de transformateur pour créer dans le circuit électrique fermé ladite différence de potentiel.

6. Procédé selon la revendication 4 ou 5, pour le convertisseur électrique dans lequel le ou chaque circuit électrique primaire ou secondaire (10, 12) comporte plusieurs étages électriques formés chacun par deux enroulements consécutifs propres à être raccordés en parallèle, et par les interrupteurs commandables raccordant entre eux ces deux enroulements, **caractérisé en que** le procédé comprend l'étape de commander (en 76 ; 94) uniquement le ou chaque interrupteur commandable du même étage que celui contenant ledit au moins un interrupteur commandable à tester pour former le circuit électrique fermé.

7. Procédé selon la revendication 6, pour le convertisseur électrique dans lequel le circuit électrique secondaire (12) comporte :
- N enroulements secondaires raccordés en série,
- un premier et un second jeux de N+1 interrupteurs (Sᵢ, S'ᵢ) commandables, les N+1 interrupteurs commandables d'un même jeu étant directement reliés entre eux par une borne commune et raccordés chacun par l'autre borne entre deux enroulements secondaires respectifs du circuit électrique secondaire (12),
**caractérisé en ce que** le procédé comporte l'étape de commander (en 76 ; 96) uniquement un interrupteur commandable du premier jeu et deux interrupteurs commandables du second jeu pour créer ladite différence de potentiel dans le circuit électrique fermé.

8. Procédé selon l'une quelconque des revendications 4 à 7, pour le convertisseur électrique dans lequel le circuit électrique secondaire (12) comporte :
- N enroulements secondaires raccordés en série,
- un premier et un second jeux de N+1 interrupteurs (Sᵢ, S'ᵢ) commandables, les N+1 interrupteurs commandables d'un même jeu étant directement reliés entre eux par une borne commune et raccordés chacun par l'autre borne entre deux enroulements secondaires respectifs du circuit électronique secondaire (12),
**caractérisé en ce qu'**il comporte les étapes consistant à :
- commander (en 114) uniquement au moins un interrupteur commandable du circuit électrique secondaire (12) pour former ledit circuit électrique fermé,
- raccorder (en 110) la source d'alimentation (42) entre des bornes de sortie dudit circuit électrique secondaire (12), et
- analyser (en 118) ledit paramètre représentatif de l'intensité du courant engendré au niveau des mêmes bornes que celles utilisées pour raccorder la source d'alimentation.

9. Procédé selon l'une quelconque des revendications précédentes, dans lequel les interrupteurs commandables commandés comprennent au moins un dispositif de commutation bidirectionnel en courant et monodirectionnel en tension dans l'état passant et unidirectionnel en courant dans l'état non passant.

10. Système de détection d'au moins une défaillance d'au moins un interrupteur commandable (Pᵢ, P'ᵢ, Sᵢ, S'ᵢ) à tester présent dans un convertisseur électronique (2) comportant des générateurs (Tᵢ) raccordés entre eux par l'intermédiaire d'interrupteurs (Pᵢ, P'ᵢ, Sᵢ, S'ᵢ) commandables de manière à raccorder les mêmes générateurs soit en parallèle, soit en série, **caractérisé en ce que** le système de détection comporte un calculateur électronique (50) apte à :
- commander les interrupteurs commandables du convertisseur électronique (2) pour former un circuit électrique fermé unidirectionnel en courant reliant entre elles les bornes du ou de chaque interrupteur commandable à tester,
- commander la création d'une différence de potentiel propre à engendrer un courant dans le circuit électrique fermé, propre à traverser l'interrupteur commandable à tester, à partir d'une source d'alimentation raccordée entre soit des bornes d'entrée, soit des bornes de sortie du convertisseur électronique (2), et
- analyser aux bornes du convertisseur électronique auxquelles est raccordée la source d'alimentation (2) les valeurs d'un paramètre représentatif de l'intensité du courant engendré par la différence de potentiel dans le circuit électrique fermé pour en déduire une information de défaillance dudit au moins un interrupteur commandable à tester.

11. Support (52) d'enregistrement d'informations comportant des instructions ayant pour conséquence qu'un calculateur électronique (50) met en oeuvre des étapes d'un procédé, conforme à l'une quelconque des revendications 1 à 9, lorsque lesdites instructions sont exécutées par le calculateur électronique (50).

## Claims

1. Method for detecting at least one fault in at least one controllable switch to be tested, said switch being present in an electronic converter comprising generators (Tᵢ) that are interconnected by means of controllable switches (Pᵢ, P'ᵢ, Sᵢ, S'ᵢ), in such a way as to connect the same generators either in parallel or in series,
**characterised in that** said method comprises the following steps:
- controlling (at 76; 94; 114) the controllable switches of the electronic converter (2) in order to form a closed electrical circuit which is unidirectional in current and which interconnects the terminals of the controllable switch to be tested or of each controllable switch to be tested,
- controlling the appearance (at 78; 96; 110) of a current in the closed electrical circuit, suitable for bridging the controllable switch to be tested, from a power source connected between either the input terminals or the output terminals of the electronic converter (2), and
- analysing (at 80; 98; 118), at the terminals of the electronic converter to which the power source is connected, the values of a parameter representing the strength of the current in the closed electrical circuit, in order to derive therefrom fault information from at least one said controllable switch to be tested.

2. Method according to claim 1, **characterised in that**, in the event that the fault to be detected is a blocking of at least one said controllable switch to be tested in an on-state which permits the appearance of current in the closed electrical circuit, the method includes the step of controlling (at 75; 116) at least one said controllable switch to be tested towards an off-state which does not permit the appearance of current in the closed electrical current, and to derive therefrom, at the time of the analysis (at 80; 118) that at least one said controllable switch to be tested is faulty if the values of the parameter representing the strength of the current correspond to a short-circuit current in the closed electrical circuit.

3. Method according to one of the above claims,
**characterized in that**, in the event that the fault to be detected is a blocking of at least one said controllable switch in the off-state which does not permit the appearance of current in the closed electrical circuit, the method includes the step of controlling (at 94; 116) at least one said controllable switch to be tested towards the on-state which permits the appearance of current in the closed electrical circuit, and to deduce, at the time of the analysis (at 98; 118), that at least one said controllable switch to be tested is faulty if the values of said parameter representing the strength of the current correspond to an absence of short-circuit current in the closed electrical circuit.

4. Method according to one of the above claims, for the electronic converter in which:
- the generators are formed by transformer windings (Tᵢ) that are magnetically independent of one another,
- the electronic converter (2) comprises a primary electrical circuit (10) interconnecting the primary transformer windings (Tᵢ), and a secondary electrical circuit interconnecting the secondary windings, the primary and secondary electrical circuits being electrically insulated from one another, and
**characterized in that** the method includes the step of controlling (at 75; 94) certain controllable switches of a single one of these primary and secondary electrical circuits (10; 12) in order to form said closed electrical circuit and to control (at 76; 96) certain controllable switches of the other primary or secondary electrical circuit, in order to create a potential difference suitable for generating a current in the closed electrical circuit.

5. Method according to claim 4, **characterized in that** it consists of supplying at least two transformer windings in order to create said potential difference in the closed electrical circuit.

6. Method according to claim 4 or 5, for the electrical converter in which the primary or secondary circuit or each primary or secondary circuit (10, 12) comprises several electrical stages each formed by two consecutive windings suitable for being connected in parallel, and by the controllable switches that interconnect said two windings, **characterized in that** the method includes the step of controlling (at 76, 94) only the controllable switch or each controllable switch at the same stage as the one containing at least one said controllable switch to be tested, in order to form the closed electrical circuit.

7. Method according to claim 6, for the electrical circuit in which the secondary electrical circuit (12) comprises:
- N secondary windings connected in series,
- a first and a second set of N+1 controllable switches (Sᵢ, S'ᵢ), said N+1 controllable switches in the same set being directly interconnected by a common terminal and each one being connected by the other terminal between two respective secondary windings of the secondary electrical circuit (12),
**characterized in that** the method comprises the step for controlling (at 76; 96) only one controllable switch from the first set and two controllable switches from the second set in order to create the said potential difference in the closed electrical circuit.

8. Method according to one of claims 4 to 7, for the electrical converter in which the secondary electrical circuit (12) comprises:
- N secondary windings connected in series
- a first and a second set of N+1 controllable switches (Sᵢ, S'ᵢ), said N+1 controllable switches in the same set being directly interconnected by a common terminal and each one being connected by the other terminal between two respective secondary windings of the secondary electronic circuit (12),
**characterized in that** it comprises the steps consisting of:
- controlling (at 114) only at least one controllable switch of the secondary electrical circuit (12) in order to form said closed electrical circuit,
- connecting (at 110) the power source (42) between the output terminals of said secondary electrical circuit (12), and
- analyzing (at 118) said parameter representing the strength of the current generated on the level of the same terminals as those used for connecting the power source.

9. Method according to one of the above claims, in which the controllable switches that are controlled comprise at least one switching device which is bidirectional in current and unidirectional in voltage in the on-state, and unidirectional in current in the off-state.

10. System for detecting at least one fault in at least one controllable switch (Pᵢ, P'ᵢ, Sᵢ, S'ᵢ) to be tested, said switch being present in an electronic converter (2) comprising generators (Tᵢ,) interconnected by means of controllable switches (Pᵢ, P'ᵢ, Sᵢ, S'ᵢ) in such a way as to connect the same generators either in parallel or in series, **characterized in that** the detection system comprises an electronic calculator (50) suitable for:
- controlling the controllable switches of the electronic converter (2) in order to form a closed electrical circuit which is unidirectional in current and which interconnects the terminals of the controllable switch to be tested or of each controllable switch to be tested,
- controlling the creation of a potential difference suitable for generating a current in the closed electrical circuit, suitable for bridging the controllable switch to be tested, from a power source connected between either the input terminals or the output terminals of the electronic converter (2), and
- analyzing, at the terminals of the electronic converter (2) to which the power source is connected, the values of a parameter representing the strength of the current generated by the potential difference in the closed electrical circuit, in order to derive therefrom fault information from at least one said controllable switch to be tested.

11. Information storage medium (52) comprising instructions, the consequence of which is that an electronic calculator (50) initiates the steps of a method in accordance with one of claims 1 to 9, when said instructions are executed by the electronic calculator (50).

## Patentansprüche

1. Verfahren zur Detektion von mindestens einem Versagen von mindestens einem zu testenden steuerbaren Schalter, der in einem Stromrichter (2) vorhanden ist, welcher Generatoren (Tᵢ) aufweist, die über steuerbare Schalter (P₁, P'ᵢ, Sᵢ, S'ᵢ) miteinander verbunden sind, sodass die Generatoren entweder parallel oder in Reihe geschaltet sind,
**dadurch gekennzeichnet, dass** das Verfahren die Folgenden Schritte umfasst:
- das Steuern (bei 76; 94; 114) der steuerbaren Schalter des Stromrichters (2) zur Bildung eines für Strom unidirektionalen geschlossenen Stromkreises, der die Anschlussklemmen des oder eines jeden zu testenden steuerbaren Schalters miteinander verbindet;
- das Steuern des Auftretens (bei 78; 96; 110) eines Stroms im geschlossenen Stromkreis, der dazu geeignet ist, durch den zu testenden steuerbaren Schalter zu fließen, ausgehend von einer Versorgungsquelle, die zwischen entweder Eingangsklemmen oder Ausgangsklemmen des Stromrichters (2) angeschlossen ist,
- das Analysieren (bei 80; 98; 118) an den Anschlussklemmen des Stromrichters, an denen die Versorgungsquelle angeschlossen ist, der Werte eines Parameters, der für die Stärke des Stroms im geschlossenen Stromkreis repräsentativ ist, um daraus eine Versagensinformation über den mindestens einen zu testenden steuerbaren Schalter abzuleiten.

2. Verfahren nach Anspruch 1, **dadurch gekennzeichnet, dass** dann, wenn das zu detektierende Versagen eine Sperre des mindestens einen zu testenden steuerbaren Schalters in einem leitenden Zustand, der das Auftreten des Stroms im geschlossenen Stromkreis zulässt, ist, das Verfahren den Schritt des Steuerns (bei 75; 116) des mindestens einen zu testenden steuerbaren Schalters hin zu einem nicht leitenden Zustand, der das Auftreten des Stroms im geschlossenen Stromkreis nicht zulässt, und das Ableiten im Zuge der Analyse (bei 80; 118) umfasst, dass beim mindestens einen zu testenden Schalter ein Versagen vorliegt, wenn die Werte des Parameters, der für die Stärke des Stroms repräsentativ ist, einem Kurzschlussstrom im geschlossenen Stromkreis entspricht.

3. Verfahren nach einem der vorangegangenen Ansprüche, **dadurch gekennzeichnet, dass** dann, wenn das zu detektierende Versagen eine Sperre des mindestens einen zu testenden steuerbaren Schalters im nicht leitenden Zustand, der das Auftreten des Stroms im geschlossenen Stromkreis nicht zulässt, ist, das Verfahren den Schritt des Steuerns (bei 94; 116) des mindestens einen zu testenden steuerbaren Schalters hin zum leitenden Zustand, der das Auftreten des Stroms im geschlossenen Stromkreis zulässt, und das Ableiten im Zuge der Analyse (bei 98; 118) umfasst, dass beim mindestens einen zu testenden steuerbaren Schalter ein Versagen vorliegt, wenn die Werte des Parameters, der für die Stärke des Stroms repräsentativ ist, einer Abwesenheit von Kurzschlussstrom im geschlossenen Stromkreis entspricht.

4. Verfahren nach einem der vorangegangenen Ansprüche für den Stromrichter, wobei:
- die Generatoren aus Spulen von Transformatoren (Tᵢ) gebildet sind, die voneinander magnetisch unabhängig sind,
- der Stromrichter (2) einen Primärstromkreis (10), der die Primärspulen der Transformatoren (Tᵢ) miteinander verbindet, sowie einen Sekundärstromkreis (12), der die Sekundärspulen miteinander verbindet, aufweist, wobei der Primär- und der Sekundärstromkreis voneinander elektrisch isoliert sind, und
**dadurch gekennzeichnet, dass** das Verfahren den Schritt des Steuerns (bei 75; 94) gewisser steuerbarer Schalter von nur einem aus dem Primär- und Sekundärstromkreis (10; 12), um den geschlossenen Stromkreis zu bilden, und des Steuerns (bei 76; 96) gewisser steuerbarer Schalter des anderen aus dem Primär- und Sekundärstromkreis umfasst, um eine Potentialdifferenz zu erzeugen, die dazu geeignet ist einen Strom im geschlossenen Stromkreis zu bewirken.

5. Verfahren nach Anspruch 4, **dadurch gekennzeichnet, dass** es darin besteht, mindestens zwei Transformatorspulen zu speisen, um im geschlossenen Stromkreis die Potentialdifferenz zu erzeugen.

6. Verfahren nach Anspruch 4 oder 5 für den Stromrichter, wobei der oder jeder Primär- oder Sekundärstromkreis (10, 12) mehrere elektrische Stufen umfasst, die jeweils aus zwei aufeinander folgenden Spulen, die dazu geeignet sind, parallel geschaltet zu werden, und aus den steuerbaren Schaltern, die diese Spulen miteinander verbinden, gebildet sind, **dadurch gekennzeichnet, dass** das Verfahren den Schritt des Steuerns (bei 76; 94) von ausschließlich dem oder jedem steuerbaren Schalter der gleichen Stufe wie jene, die den mindestens einen zu testenden steuerbaren Schalter enthält, umfasst, um den geschlossenen Stromkreis zu bilden.

7. Verfahren nach Anspruch 6 für den Stromrichter, wobei der Sekundärstromkreis (12) Folgendes umfasst:
- N in Reihe geschaltete Sekundärspulen,
- einen ersten und einen zweiten Satz aus N+1 steuerbaren Schaltern (Sᵢ, S'ᵢ), wobei die N+1 steuerbaren Schalter ein und desselben Satzes durch eine gemeinsame Anschlussklemme direkt miteinander verbunden sind und jeweils über die andere Anschlussklemme zwischen zwei entsprechenden Sekundärspulen des Sekundärstromkreises (12) angeschlossen sind,
**dadurch gekennzeichnet, dass** das Verfahren den Schritt des Steuerns (bei 76; 96) von ausschließlich einem steuerbaren Schalter des ersten Satzes und zwei steuerbaren Schaltern des zweiten Satzes umfasst, um die Potentialdifferenz im geschlossenen Stromkreis zu erzeugen.

8. Verfahren nach einem der Ansprüche 4 bis 7 für den Stromrichter, wobei der Sekundärstromkreis (12) Folgendes umfasst:
- N in Reihe geschaltete Sekundärspulen,
- einen ersten und einen zweiten Satz aus N+1 steuerbaren Schaltern (Sᵢ, S'ᵢ), wobei die N+1 steuerbaren Schalter ein und desselben Satzes durch eine gemeinsame Anschlussklemme direkt miteinander verbunden sind und jeweils über die andere Anschlussklemme zwischen zwei entsprechenden Sekundärspulen des Sekundärstromkreises (12) angeschlossen sind,
**dadurch gekennzeichnet, dass** es die folgenden Schritte umfasst:
- das Steuern (bei 114) von ausschließlich mindestens einem steuerbaren Schalter des Sekundärstromkreises (12), um den geschlossenen Stromkreis zu bilden,
- das Anschließen (bei 110) der Versorgungsquelle (42) zwischen den Ausgangsklemmen des Sekundärstromkreises (12), und
- das Analysieren (bei 118) des für die Stärke des Stroms repräsentativen Parameters, der auf der Ebene der gleichen Anschlussklemmen bewirkt ist, die auch zum Anschließen der Versorgungsquelle verwendet werden.

9. Verfahren nach einem der vorangegangenen Ansprüche, wobei die gesteuerten steuerbaren Schalter mindestens eine Schaltvorrichtung umfassen, die im leitenden Zustand bidirektional für Strom und monodirektional für Spannung ist und im nicht leitenden Zustand unidirektional für Strom ist.

10. System zur Detektion von mindestens einem Versagen von mindestens einem zu testenden steuerbaren Schalter (Pᵢ, P'ᵢ, Sᵢ, S'ᵢ), der in einem Stromrichter (2) vorhanden ist, welcher Generatoren (Tᵢ) aufweist, die über steuerbare Schalter (Pᵢ, P'ᵢ, Sᵢ, S'ᵢ) miteinander verbunden sind, sodass die Generatoren entweder parallel oder in Reihe geschaltet sind, **dadurch gekennzeichnet, dass** das Detektionssystem einen elektronischen Rechner (50) umfasst, der zu Folgendem fähig ist:
- Steuern der steuerbaren Schalter des Stromrichters (2) zur Bildung eines für Strom unidirektionalen geschlossenen Stromkreises, der die Anschlussklemmen des oder eines jeden zu testenden steuerbaren Schalters miteinander verbindet:
- Steuern der Erzeugung einer Potentialdifferenz, die dazu geeignet ist, einen Strom im geschlossenen Stromkreis zu bewirken, der dazu geeignet ist, durch den zu testenden steuerbaren Schalter zu fließen, ausgehend von einer Versorgungsquelle, die zwischen entweder Eingangsklemmen oder Ausgangsklemmen des Stromrichters (2) angeschlossen ist, und
- das Analysieren an den Anschlussklemmen des Stromrichters (2), an denen die Versorgungsquelle angeschlossen ist, der Werte eines Parameters, der für die Stärke des Stroms, der durch die Potentialdifferenz im geschlossenen Stromkreis bewirkt ist, repräsentativ ist, um daraus eine Versagensinformation über den mindestens einen zu testenden steuerbaren Schalter abzuleiten.

11. Träger (52) zur Aufzeichnung von Informationen, die Befehle umfassen, die zur Folge haben, dass ein elektronischer Rechner (50) Schritte eines Verfahren entsprechend einem der Ansprüche 1 bis 9 umsetzt, wenn diese Befehle vom elektronischen Rechner (50) ausgeführt werden.
